# FASCICULE DE BREVET EUROPEEN

(11) **EP 1 274 292 B1**
(45) Date de publication et mention de la délivrance du brevet: **23.04.2008**
(21) Numéro de dépôt: 02291556.5
(22) Date de dépôt: 21.06.2002
(51) Int. Cl.: H05K 7/20

(54) **Coffre pour convertisseur de puissance**
Gehäuse für einen Stromwandler
Casing for a power converter

(30) Priorité: 06.07.2001 FR 0109007
(43) Date de publication de la demande: 08.01.2003
(73) Titulaire: Alstom, 92300 Levallois-Perret (FR)
(72) Inventeur: Mermet-Guyennet, Michel, 65390 Auresan (FR)
(74) Mandataire: de Lambilly Delorme, Marie Pierre

(56) Documents cités:
- DE-C- 4 307 902
- GB-A- 2 076 141
- US-A- 5 404 272
- US-B1- 6 212 074

## Description

L'invention se rapporte à un coffre pour convertisseur de puissance destiné notamment à équiper une chaîne de traction d'un véhicule ferroviaire.

Il est connu que les performances des modules électroniques de puissance sont limitées par la température atteinte par les composants électroniques de puissance en fonctionnement. Cette température provient d'un échauffement dû à la dissipation de puissance par effet joule. Par exemple, au-delà de 150°C, une puce silicium voit ses performances fortement dégradées. En outre, la fiabilité des composants électroniques de puissance se dégrade fortement au-dessus de 100°C.

De ce fait, il est très important de disposer d'un système de refroidissement pour évacuer la chaleur produite, de façon à maintenir, dans les composants, une température de fonctionnement optimale et ainsi pouvoir augmenter les puissances utilisables. En particulier, avec certains composants tels que les composants IGBT, le courant maximal admissible est fonction de la quantité de chaleur que le dispositif est capable d'évacuer.

La solution la plus couramment utilisée sur les véhicules ferroviaires pour assurer le refroidissement des modules de puissance utilisés dans les convertisseurs consiste à accoler un radiateur en aluminium, muni d'ailettes de refroidissement, contre chacune des différentes embases des modules de puissance, l'ensemble des différents modules munis de leur radiateur de refroidissement étant disposés dans un coffre situé sous le véhicule et ouvert sur les côtés afin de permettre la circulation d'un flux d'air, notamment lors du déplacement du véhicule.

Une telle solution présente toutefois l'inconvénient de ne pas permettre un refroidissement très efficace des modules de puissances, en particulier lorsque le véhicule est à l'arrêt et qu'aucun flux d'air ne circule autour des différents radiateurs de refroidissement. Un tel manque de refroidissement contraint à l'utilisation d'un plus grand nombre de composants de puissance, afin de réduire l'intensité du courant dans chacun des composants de puissance et donc leur échauffement, ce qui présente l'inconvénient d'augmenter le coût, l'encombrement et le poids des convertisseurs de puissance.

Il peut être en partie remédié à ce type de problème en utilisant des ventilateurs pour créer un flux d'air permanent sur les radiateurs de refroidissement. Toutefois, de tels ventilateurs présentent l'inconvénient de générer beaucoup de bruits, d'être peu fiables et de posséder une faible durée de vie dans l'environnement ferroviaire.

Le document DE 43 07 902 décrit un coffre pour convertisseur de puissance tel que défini dans le préambule de la revendication 1.

Le but de la présente invention est donc de proposer un coffre pour modules électroniques de puissance qui assure, avec une grande fiabilité, un excellent refroidissement des composants de puissance dans un encombrement réduit, permettant ainsi de réduire le nombre de modules électroniques de puissance nécessaires à la réalisation d'une installation de type onduleur dans une chaîne de traction de véhicule ferroviaire.

A cet effet, l'invention a pour objet un coffre pour convertisseur de puissance, destiné notamment à équiper une chaîne de traction d'un véhicule ferroviaire, comprenant des modules électroniques de puissance constitués d'un ou plusieurs composants semi-conducteurs de puissance montés sur un substrat, un socle comportant un panneau inférieur à double parois présentant une paroi interne, disposée vers l'intérieur du coffre, sur laquelle est accolée au moins un substrat supportant un composant de puissance, le panneau inférieur se prolongeant par au moins deux panneaux latéraux à double parois dont les parois externes sont refroidies au moyen d'ailettes de refroidissement, et en ce que les deux parois du panneau inférieur délimitent un volume creux rempli partiellement par un liquide réfrigérant et contenant un matériau perméable, thermiquement conducteur, réalisant un pont thermique entre les deux parois.

Selon des modes particuliers de réalisation, le coffre selon l'invention peut comprendre l'une ou plusieurs des caractéristiques suivantes prises isolément ou selon toutes les combinaisons techniquement possibles :
- le matériau perméable, thermiquement conducteur est un matériau poreux, tel qu'une mousse de cuivre, injecté dans le volume creux défini par les deux parois du panneau inférieur ;
- le matériau perméable, thermiquement conducteur, est constitué par un empilement de grilles en cuivre ou en aluminium entre les deux parois du panneau inférieur ;
- les panneaux latéraux comportent une paroi externe en accordéon définissant les ailettes de refroidissement ;
- les panneaux latéraux comportent une paroi externe plane sur laquelle sont rapportées les ailettes de refroidissement ;
- un ou plusieurs composants passifs sont accolés à la paroi interne des panneaux latéraux à double paroi ;
- un couvercle, de forme complémentaire au socle, vient fermer le coffre ;
- le panneau inférieur du socle comporte une paroi externe plane ;
- le panneau inférieur du socle comporte une paroi externe refroidie par des ailettes de refroidissement ;
- les composants de puissance sont des composants IGBT.

On comprendra mieux les buts, aspects et avantages de la présente invention, d'après la description donnée ci-après de plusieurs variantes de réalisation de l'invention, présentés à titre d'exemples non limitatifs, en se référant aux dessins annexés, dans lesquels :
- la figure 1 est une vue en perspective d'un coffre pour modules électroniques de puissance selon un premier mode de réalisation de l'invention ;
- la figure 2 est une vue en coupe transversale du socle du coffre de la figure 1, représenté seul ;
- la figure 3 est une vue en perspective d'une variante de réalisation du coffre selon l'invention ;
- la figure 4 est en vue coupe en coupe transversale du socle du coffre de la figure 3, représenté seul ;
- la figure 5 est une vue en coupe transversale d'une autre variante de réalisation du coffre selon l'invention.

Pour faciliter la lecture du dessin, seuls les éléments nécessaires à la compréhension de l'invention ont été représentés. Les mêmes éléments portent les mêmes références d'une figure à l'autre.

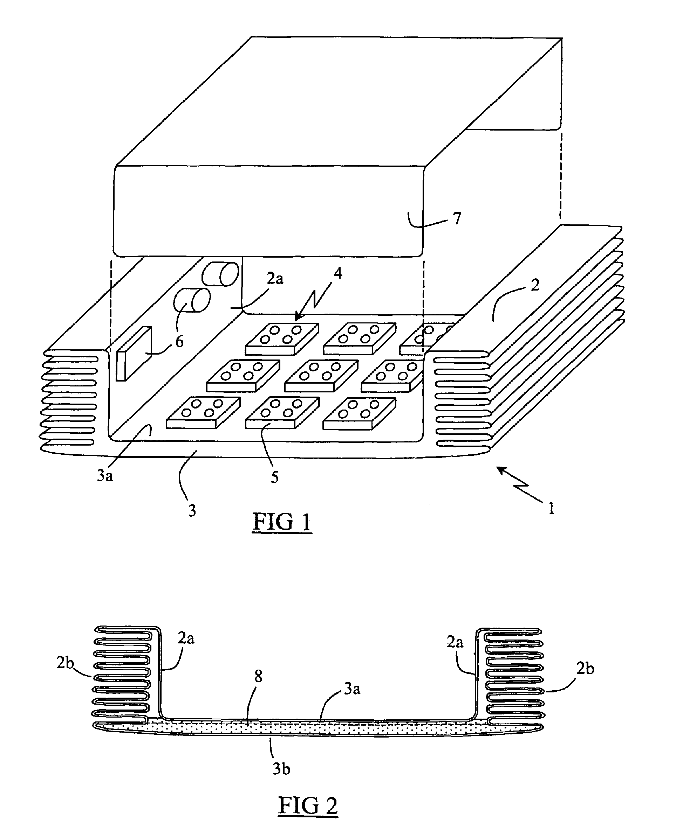

La figure 1 représente un coffre pour convertisseur de puissance destiné à équiper une chaîne de traction d'un métro.

Conformément à cette figure, le coffre comporte un socle 1 muni d'un panneau inférieur 3 à double paroi 3a et 3b se prolongeant par deux panneaux latéraux 2 s'étendant perpendiculairement au panneau inférieur 3. Les deux panneaux latéraux 2 sont également à double paroi 2a et 2b et sont symétriques par rapport au plan longitudinal passant par le centre du coffre parallèlement aux panneaux latéraux 2. Le socle 1 est préférentiellement réalisé en matériau métallique bon conducteur de chaleur.

Le panneau inférieur 3 supporte sur sa paroi interne 3a, orientée vers l'intérieur du coffre, des modules de puissance 4 destinés au fonctionnement de l'onduleur, chaque module de puissance étant principalement constitué d'un ou plusieurs composants de puissance de type IGBT montés sur des pistes conductrices réalisées sur un substrat 5 en matériau électriquement isolant et bon conducteur de chaleur, par exemple du nitrure d'aluminium AlN, la face inférieure du substrat 5 étant accolée directement à la paroi interne 3a et étant soudée sur le socle 1 au moyen d'une brasure tendre.

Les panneaux latéraux 2 supportent sur leur paroi interne 2a des composants électroniques 6 qui sont préférentiellement des composants passifs, par exemple de type condensateur, présentant la particularité d'être moins dissipatifs que les composants de puissance intégrés dans les modules 4 disposés sur le panneau inférieur 3 du socle 1.

La paroi externe 2b de chaque panneau latéral 2 est en accordéon de manière à former de multiples ailettes de refroidissement, disposées perpendiculairement au panneau latéral 2, assurant un échange thermique avec l'air ambiant. Ces ailettes de refroidissement s'étendent parallèlement à la direction axiale du métro de manière à être balayées par un flux d'air lors du déplacement du métro.

Le coffre est fermé par un couvercle 7 possédant une forme complémentaire au socle 1 et assurant une protection contre les agressions extérieures des différents composants 4,6 situés dans le coffre.

Conformément à la figure 2, où le socle 1 est représenté seul, le panneau inférieur 3 comporte un volume creux, disposé entre les deux parois 3a et 3b, qui est rempli d'un matériau perméable 8, tel que de la mousse de cuivre, assurant une forte conduction thermique entre la paroi interne 3a et la paroi externe 3b du panneau inférieur 3. Le panneau inférieur 3 contient également un liquide réfrigérant, tel que de l'eau, qui rempli partiellement les pores de la mousse de cuivre 8, le niveau de liquide étant représenté en pointillé sur la figure 2. Dans une variante de réalisation non représentée, le matériau perméable 8 peut également être constitué d'un empilement de grilles, par exemple en cuivre ou en aluminium, assurant la même fonction de pont thermique entre la paroi interne 3a et la paroi externe 3b.

Le socle 1 ainsi formé constitue un système diphasique dans lequel le liquide contenu dans la mousse de cuivre 8 s'évapore au travers des pores lors de l'élévation de température provoquée par le fonctionnement des différents composants de puissance, la vapeur ainsi libérée cheminant au travers des panneaux latéraux 2 et se condensant sur la paroi externe 2b, au niveau des ailettes de refroidissement. Le liquide condensé et refroidi retombe ensuite dans la mousse de cuivre 8 du panneau inférieur 3 et contribue au refroidissement des modules de puissance disposés sur la paroi interne 3a du panneau inférieur 3.

Les composants passifs, disposés sur les panneaux latéraux 2, sont quant à eux refroidis par conduction au travers de la paroi interne 2a des panneaux latéraux 2.

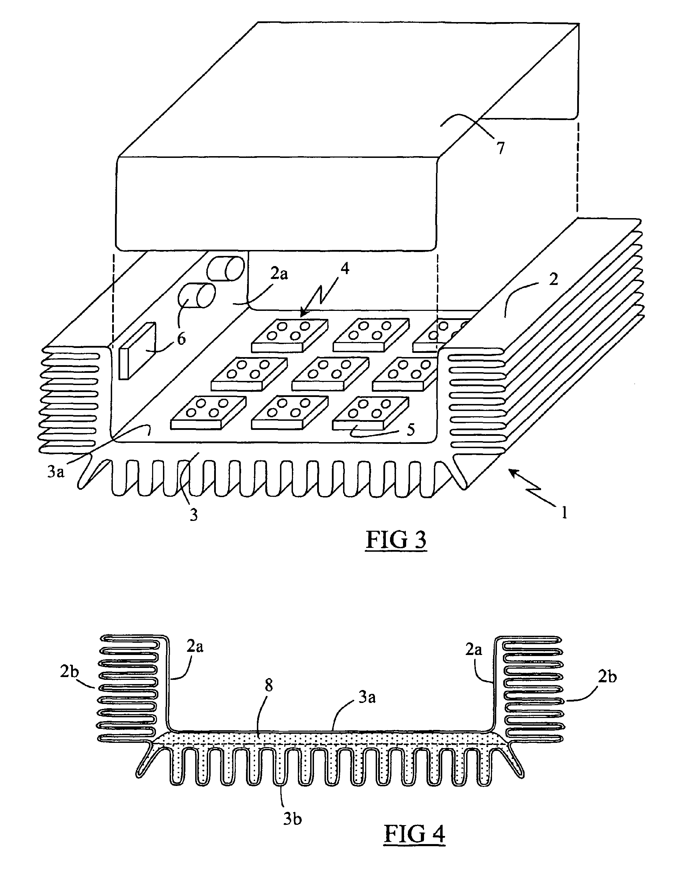

Les figures 3 et 4 présente une variante de réalisation du coffre selon l'invention dans laquelle la panneau inférieur 3 du socle comporte une paroi externe 3b en accordéon formant de multiples ailettes renforçant l'efficacité du refroidissement. Dans cette variante, les panneaux latéraux 2 du socle 1, le couvercle 7, l'implantation des différents modules de puissance 4 et des composants passifs 6 restent inchangés par rapport au mode de réalisation précédemment décrit.

Conformément à la figure 4, le panneau inférieur 3 est creux et est rempli d'une mouse de cuivre 8 venant combler l'intérieur des ailettes de refroidissement ainsi que l'espace séparant la paroi interne 3a de la paroi externe 3b afin de réaliser un pont thermique entre les deux parois 3a et 3b. De manière similaire au mode de réalisation précédemment décrit, le matériau poreux 8 est rempli partiellement avec un liquide réfrigérant tel que de l'eau, le niveau du liquide étant représenté en pointillé sur la figure 4.

Un tel coffre pour convertisseur de puissance constitue un système diphasique fonctionnant de manière analogue au coffre décrit sur les figures 1 et 2, le refroidissement des composants de puissance étant encore amélioré par la surface d'échange plus importante.

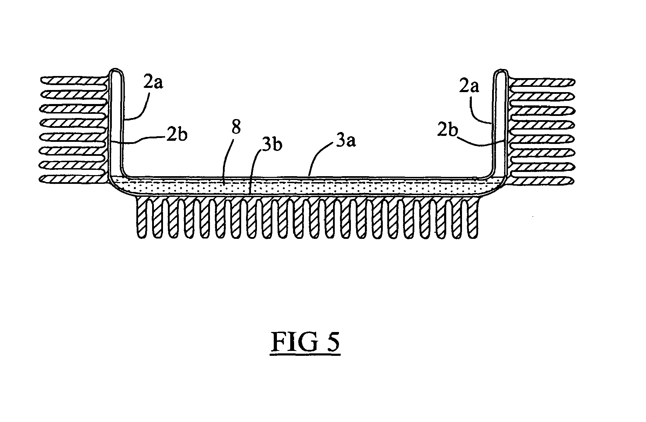

La figure 5 représente une variante de réalisation du coffre de la figure 3 dans laquelle les parois externes 2b et 3b des panneaux latéraux 2 et inférieur 3 sont planes et les ailettes de refroidissement sont rapportées, par exemple par soudage. Le fonctionnement d'un tel coffre pour convertisseur de puissance reste inchangé par rapport au coffre décrit aux figures 3 et 4. Une telle variante de réalisation présente l'avantage de simplifier la fabrication du coffre.

Les coffres pour convertisseur de puissance selon l'invention présentent l'avantage d'assurer une excellente protection des modules de puissances contre les agressions extérieures grâce au confinement de ces derniers dans le coffre tout en assurant un refroidissement très efficace.

De plus, le refroidissement procuré par de tels coffres reste également efficace lorsque le véhicule est à l'arrêt grâce l'évaporation du liquide de refroidissement dans le panneau inférieur du socle.

Bien entendu, l'invention n'est nullement limitée au mode de réalisation décrit et illustré qui n'a été donné qu'à titre d'exemple.

## Revendications

1. Coffre pour convertisseur de puissance, destiné notamment à équiper une chaîne de traction d'un véhicule ferroviaire, comprenant des modules électroniques de puissance (4) constitués d'un ou plusieurs composants semi-conducteurs de puissance montés sur un substrat (5), un socle (1) comportant un panneau inférieur (3) à double parois (3a, 3b) présentant une paroi interne (3a), disposée vers l'intérieur du coffre, sur laquelle est accolée au moins un substrat (5) supportant un composant de puissance, ledit panneau inférieur (3) se prolonge par au moins deux panneaux latéraux (2) à double parois (2a, 2b) les deux parois (3a, 3b) du panneau inférieur (3) délimitant un volume creux rempli partiellement par un liquide réfrigérant **caractérisé en ce que** les parois externes (2b) desdits panneaux latéraux (2) sont refroidies au moyen d'ailettes de refroidissement et **en ce que** le volume creux délimité par les deux parois (3a,3b) du panneau inférieur (3) contient également un matériau perméable thermiquement conducteur (8) réalisant un pont thermique entre les deux parois (3a, 3b).

2. Coffre pour convertisseur de puissance selon la revendication 1, **caractérisé en ce que** ledit matériau perméable thermiquement conducteur (8) est un matériau poreux, tel qu'une mousse de cuivre, injecté dans ledit volume creux défini par les deux parois (3a, 3b).

3. Coffre pour convertisseur de puissance selon la revendication 1, **caractérisé en ce que** ledit matériau perméable thermiquement conducteur (8) est constitué par un empilement de grilles en cuivre ou en aluminium entre les deux parois (3a, 3b).

4. Coffre pour convertisseur de puissance selon l'une quelconque des revendications 1 à 3, lesdits panneaux latéraux (2) comportent une paroi externe (2b) en accordéon définissant lesdites ailettes de refroidissement.

5. Coffre pour convertisseur de puissance selon l'une quelconque des revendications 1 à 3, **caractérisé en ce que** lesdits panneaux latéraux (2) comportent une paroi externe (2b) plane sur laquelle sont rapportées lesdites ailettes de refroidissement.

6. Coffre pour convertisseur de puissance selon l'une quelconque des revendications 1 à 5, **caractérisé en ce qu'**un ou plusieurs composants passifs sont accolés à la paroi interne (2a) des panneaux latéraux (2) à double paroi.

7. Coffre pour convertisseur de puissance selon l'une quelconque des revendications 1 à 6, **caractérisé en ce qu**'un couvercle (7), de forme complémentaire au socle (1), vient fermer ledit coffre.

8. Coffre pour convertisseur de puissance selon l'une quelconque des revendications 1 à 7, **caractérisé en ce que** le panneau inférieur (3) du socle (1) comporte une paroi externe (3b) plane.

9. Coffre pour convertisseur de puissance selon l'une quelconque des revendications 1 à 7, **caractérisé en ce que** le panneau inférieur (3) du socle (1) comporte une paroi externe (3b) refroidie par des ailettes de refroidissement.

10. Coffre pour convertisseur de puissance selon l'une quelconque des revendications 1 à 9, **caractérisé en ce que** les composants de puissance sont des composants IGBT.

## Claims

1. Power converter housing, intended in particular for fitting to a railway vehicle drive chain, which includes power electronic modules (4), made up of one or more power semi-conductor components mounted on a substrate (5), a base (1) which includes a lower panel (3) with double walls (3a, 3b) which has an internal wall (3a), arranged towards the interior of the housing, onto which is laid at least one substrate (5) supporting a power component, with the said lower panel (3) extending by means of at least two lateral panels (2) with double walls (2a, 2b), **characterised by** the fact that the external walls (2b) of the said lateral panels (2) are cooled by means of cooling fins, and by the fact that the hollow space delimited by the two walls (3a, 3b) of the lower panel (3) also contains a thermally conductive permeable material (8) which forms a thermal bridge between the two walls (3a, 3b).

2. Power converter housing according to claim 1, **characterised by** the fact that the said permeable thermally conductive material (8) is a porous material, such as a copper foam, introduced into the hollow space defined by the two walls (3a, 3b).

3. Power converter housing according to claim 1, **characterised by** the fact that the said permeable thermally conductive material (8) is made up of a stack or copper or aluminium grids between the two walls (3a, 3b).

4. Power converter housing according to any of claims 1 to 3 whatsoever, where the said lateral panels (2) include a bellows external wall (2b) which defines the said cooling fins.

5. Power converter housing according to any of claims 1 to 3 whatsoever, **characterised by** the fact that the said lateral panels (2) include a flat external wall (2b) on which the said cooling wings are carried.

6. Power converter housing according to any of claims 1 to 5 whatsoever, **characterised by** the fact that one or more passive components are laid on the internal wall (2a) of the double-walled lateral panels (2).

7. Power converter housing according to any of claims 1 to 6 whatsoever, **characterised by** the fact that a cover (7), whose shape complements that of the base (1), is used to enclose the said housing.

8. Power converter housing according to any of claims 1 to 7 whatsoever, **characterised by** the fact that the lower panel (3) of the base (1) includes a flat external wall (3b).

9. Power converter housing according to any of claims 1 to 7 whatsoever, **characterised by** the fact that the lower panel (3) of the base (1) includes an external wall (3b) which is cooled by cooling fins.

10. Power converter housing according to any of claims 1 to 9 whatsoever, **characterised by** the fact that the power components are IGBT components.

## Patentansprüche

1. Kasten für Leistungswandler, insbesondere zur Ausrüstung einer Zugkette eines Schienenfahrzeugs, weicher elektronische Leistungsmodule (4), die durch eine oder mehrere auf einem Substrat (5) angebrachte Leistungshalbleiter gebildet sind, einen Sockel (1) aufweist, welcher eine untere Platte (3) mit zwei Wänden (3a, 3b) aufweist, welche eine innere Wand (3a), angeordnet zum Inneren des Kastens hin, aufweist, an weiche wenigstens ein Substrat (5) angefügt ist, weiches eine Leistungskomponente trägt" wobei die untere Platte (3) sich in wenigstens zwei seitlichen Platten (2) mit Doppelwänden (2a, 2b) fortsetzt, wobei die beiden Wände (3a, 3b) der unteren Platte (3) ein teilweise von einer Kühlflüssigkeit ausgefülltes Hohlvolumen begrenzen, **dadurch gekennzeichnet, dass** die äußeren Wände (2b) der seitlichen Platten (2) mittels Kühlflügeln gekühlt sind, und dass das von den beiden wänden (3a, 3b) begrenzte Hohlvolumen der unteren Platte (3) auch ein wärmeleitendes durchlässiges Material (8) enthält, weiches eine wärmebrücke zwischen den beiden Wänden (3a, 3b) verwirklicht.

2. Kasten für einen Leistungswandler nach Anspruch 1, **dadurch gekennzeichnet, dass** das wärmeleitende durchlässige Material (8) ein poröses Material, wie ein Kupferschaum, ist, welcher in das durch die beiden Wände (3a, 3b) definierte Hohlvolumen eingespritzt ist.

3. Kasten für einen Leistungswandler nach Anspruch 1, **dadurch gekennzeichnet, dass** das wärmeleitende durchlässige Material (8) durch einen Stapel von Kupfer- oder Aluminiumgittern zwischen den beiden Wenden (3a, 3b) gebildet ist.

4. Kasten für einen Leistungswandler nach irgendeinem der Ansprüche 1 bis 3, wobei die seitlichen Platten eine äußere Ziehharmonikawand aufweisen, welche die Kühlftügel definiert.

5. Kasten für einen Leistungswandler nach irgendeinem der Ansprüche 1 bis 3, **dadurch gekennzeichnet, dass** die Seitenplatten (2) eine plane äußere Wand (2b) aufweisen, an weicher die Kühlflügel angesetzt sind.

6. Kasten für einen Leistungswandler nach irgendeinem der Ansprüche 1 bis 5, **dadurch gekennzeichnet, dass** eine oder mehrere passive Komponenten an die innere Wand (2a) der doppelwandigen seitlichen Platten (2) angefügt sind.

7. Kasten für einen Leistungswandler nach irgendeinem der Ansprüche 1 bis 6, **dadurch gekennzeichnet, dass** ein Deckel (7) mit zu der des Sockels (1) komplementären Form den Kasten verschließt.

8. Kasten für einen Leistungswandler nach irgendeinem der Ansprüche 1 bis 7, **dadurch gekennzeichnet, dass** die untere Platte (3) des Sockels (1) eine plane äußere Wand (3b) aufweist.

9. Kasten für einen Leistungswandler nach irgendeinem der Ansprüche 1 bis 7, **dadurch gekennzeichnet, dass** die untere Platte (3) des Sockels (1) eine durch Kühlflügel gekühlte äußere Wand (3b) aufweist.

10. Kasten für einen Leistungswandler nach irgendeinem der Ansprüche 1 bis 9, **dadurch gekennzeichnet, dass** die Leistungskomponenten IGBT-Komponenten sind.
